Europäisches Patentamt

European Patent Office

Office européen des brevets

(19)

(11) **EP 0 480 789 B1**

(12) **FASCICULE DE BREVET EUROPEEN**

(45) Date de publication et mention
de la délivrance du brevet:
**14.01.1998   Bulletin 1998/03**

(51) Int Cl.6: **C30B 1/02**, C30B 29/28

(21) Numéro de dépôt: **91402568.9**

(22) Date de dépôt: **26.09.1991**

(54) **Procédé de préparation par recuit rapide d'une couche mince en matériau cristallisé du type oxyde**

Verfahren zur Herstellung von Kristall-Dünnschichten von Typ Oxide durch eine schnelle thermische Behandlung

Process for producing an oxide type crystallised thin layer by rapid annealing

(84) Etats contractants désignés:
**DE GB IT NL**

(30) Priorité: **28.09.1990  FR 9012009**

(43) Date de publication de la demande:
**15.04.1992   Bulletin 1992/16**

(73) Titulaire: **COMMISSARIAT A L'ENERGIE ATOMIQUE**
**75015 Paris (FR)**

(72) Inventeurs:
• **Bechevet, Bernard**
  **F-38640 Claix (FR)**
• **Daval, Jacques**
  **F-38240 Meylan (FR)**
• **Rolland, Bernard**
  **F-38240 Meylan (FR)**
• **Valon, Bruno**
  **F-38100 Grenoble (FR)**

(74) Mandataire: **Dubois-Chabert, Guy et al**
**c/o BREVATOME**
**25, rue de Ponthieu**
**75008 Paris (FR)**

(56) Documents cités:
**DE-A- 3 834 963**

• **PATENT ABSTRACTS OF JAPAN vol. 8, no. 77 (C-218) (1514) 10 Avril 1984 & JP-A-59 003 091 (TOKYO SHIBURA DENKI KK) 9 Novembre 1984**
• **PATENT ABSTRACTS OF JAPAN vol. 13, no. 504 (C-653) (3852) 13 Novembre 1989 & JP-A-01 203 203 (FUJITSU LTD) 16 Août 1989**

EP 0 480 789 B1

## Description

La présente invention concerne un procédé de préparation d'une couche mince en matériau cristallisé du type oxyde.

Les matériaux de type oxyde tels que les grenats, les ferrites spinelles, les hexaferrites, les céramiques ferroélectriques, les oxydes acousto-optiques/électrooptiques, les oxydes à transition de phases et les oxydes supraconducteurs du type YBaCuO, ont des propriétés chimiques (stabilité), optiques, magnétiques, magnétooptiques, électriques, ferroélectriques, supraconductrices et/ou mécaniques attrayantes, ce qui les rend intéressants pour de nombreuses applications dans des domaines très divers allant de la mécanique à l'informatique.

Parmi ces matériaux, les couches de grenat substitué utilisées pour le stockage magnéto-optique d'informations sont particulièrement intéressantes car elles permettent de réaliser des mémoires optiques ré-inscriptibles dont les atouts sont :

- une capacité de stockage très grande (10 fois supérieure à celle des mémoires magnétiques classiques),
- une lecture optique de l'information (distance tête de lecture/disque)très grande ,
- une sensibilité aux poussières réduite,
- une amovibilité des disques, et
- une stabilité du matériau par rapport aux matériaux métalliques, terres rares - métaux de transition, qui sont facilement oxydables.

D'autres oxydes intéressants sont les titanates ferroélectriques qui peuvent être employés, soit dans les mémoires microélectroniques, soit comme générateurs d'électrons pour les écrans plats.

Pour ces applications, on utilise souvent l'oxyde sous la forme d'une couche mince, ce qui nécessite généralement une étape complémentaire de recuit pour cristalliser le matériau de la couche mince afin d'obtenir les propriétés optimales.

Etant donné la température de cristallisation de ces matériaux, le recuit doit être effectué à des températures généralement supérieures à 500°C, ce qui pose certains problèmes, notamment lorsque ces matériaux sont sous la forme de couche mince sur un substrat ne résistant pas à de telles températures, par exemple sur un substrat en verre.

Pour réaliser le recuit de la couche sur de tels substrats, on pourrait envisager d'utiliser la technique du recuit rapide qui consiste à chauffer la couche par absorption d'un rayonnement lumineux (visible ou infrarouge) afin d'éviter un chauffage du substrat. Cependant, cette technique de recuit rapide est impossible à mettre en oeuvre avec la plupart des matériaux du type oxyde car ceux-ci sont malheureusement transparents aux radiations lumineuses susceptibles d'être utilisées.

C'est le cas en particulier des couches minces d'oxydes de type ferrites, grenats, spinelles ou hexagonales, susceptibles d'être utilisées dans des dispositifs magnéto-optiques. En effet, le coefficient d'absorption du grenat est de 500 à $10000 cm^{-1}$ dans les longueurs d'onde du visible émises par une lampe classique.

La présente invention a précisément pour objet un procédé de préparation d'une couche mince d'oxyde cristallisé par un traitement de recuit sous rayonnement, qui permet de réaliser le recuit de la couche sur des substrats ne résistant pas à la température de cristallisation de cet oxyde.

On précise que dans la suite du présent texte, le terme "oxyde" désigne aussi bien un oxyde simple, qu'un oxyde mixte et que les matériaux du type oxyde mentionnés ci-dessus.

Selon l'invention, le procédé de préparation d'une couche mince, cristallisée par un traitement de recuit à partir d'un oxyde se caractérise en ce que le recuit est effectué par irradiation au moyen d'un rayonnement auquel l'oxyde de départ à l'état amorphe est transparent, et en ce que l'on prépare la couche cristallisée en effectuant les étapes suivantes :

a) préparer une couche mince d'un oxyde sous-stoechiométrique amorphe ayant la même composition que celle de l'oxyde de départ, sauf en ce qui concerne sa teneur en oxygène qui est plus faible, de façon à obtenir une couche d'oxyde sous-stoechiométrique, opaque et absorbant ledit rayonnement, et

b) soumettre la couche mince d'oxyde sous-stoechiométrique ainsi obtenue à une irradiation par ledit rayonnement pour la cristalliser.

Selon l'invention, on remplace ainsi la couche mince amorphe d'oxyde transparent par une couche opaque absorbante pour la longueur d'onde qui sera utilisée ensuite pour le recuit par irradiation, ce qui permet de réaliser ce recuit dans de bonnes conditions.

Ainsi, dans l'étape a), du procédé de l'invention, on prépare une couche mince d'oxyde sous-stoechiométrique amorphe et opaque. Ceci peut être effectué, soit pendant l'élaboration même de la couche mince en réalisant le dépôt dans des conditions appropriées, soit après dépôt d'une couche mince de l'oxyde de départ en effectuant un traitement approprié.

Aussi, selon un premier mode de mise en oeuvre du procédé de l'invention, on prépare la couche mince d'oxyde sous-stoechiométrique par pulvérisation cathodique de l'oxyde de départ sous une pression partielle d'oxygène inférieure à $135.10^{-4}$ Pa ($10^{-4}$T).

En effet, lorsqu'on prépare la couche mince par pulvérisation cathodique de l'oxyde de départ à basse température (environ 200°C), la composition de la couche amorphe déposée dépend en particulier de la pression partielle en oxygène, pendant la pulvérisation.

Ainsi, si l'on utilise une pression partielle d'oxygène faible, on obtient une réduction partielle de l'oxyde de départ, ce qui correspond à un oxyde sous-stoechiométrique en oxygène. Cette étape de réduction correspond à la réduction d'un des ions métalliques présents dans l'oxyde de départ, selon le schéma réactionnel suivant :

$$M^{m+} + ne^- \rightarrow M^{(m-n)+}$$

Cet ion métallique peut par exemple être l'ion $Fe^{3+}$ qui est réduit selon le schéma suivant :

$$Fe^{3+} + e^- \rightarrow Fe^{2+}$$

Ce phénomène chimique engendre l'opacité de la couche mince aux longueurs d'onde de la lumière du recuit rapide (RTA).

Selon un second mode de mise en oeuvre du procédé de l'invention, on prépare la couche d'oxyde sous-stoechiométrique en deux étapes, c'est-à-dire qu'on dépose tout d'abord une couche mince amorphe de l'oxyde de départ, transparente au rayonnement qui sera utilisé pour le recuit, puis on soumet la couche mince obtenue à un traitement de réduction pour la rendre sous-stoechiométrique en oxygène et opaque au rayonnement qui sera utilisé.

Ce traitement de réduction peut consister en un chauffage sous atmosphère réductrice, par exemple à une température de 200 à 450°C dans un mélange d'argon et d'hydrogène qui peut être constitué de 95% en volume d'argon et 5% en volume d'hydrogène.

Dans ce cas, étant donné que la couche est transparente, le chauffage doit être effectué dans un four classique, la température de ce four étant inférieure à la température de transformation du substrat.

Dans ce second mode de mise en oeuvre du procédé de l'invention, on peut aussi préparer la couche mince d'oxyde par pulvérisation cathodique de l'oxyde de départ, selon un procédé à basse température, mais en utilisant une pression partielle d'oxygène plus forte, c'est-à-dire une pression partielle d'oxygène supérieure à $135.10^{-4}Pa$ ($10^{-4}$ T) (1% de la pression totale).

Après avoir effectué le traitement de réduction de la couche pour réduire l'oxyde, la couche amorphe devient opaque et sous-stoechiométrique comme dans le premier mode de mise en oeuvre du procédé de l'invention, et on peut réaliser ensuite l'étape de recuit sous rayonnement.

Ceci peut être effectué dans les deux cas en utilisant un rayonnement du domaine visible ou infra-rouge et en réalisant l'irradiation sous vide, pendant une durée allant de 0,1 à 300s.

A la fin de cette étape, on obtient une couche d'oxyde cristallisée qui habituellement demeure opaque au rayonnement utilisé.

Selon le procédé de l'invention, on peut alors réaliser une étape complémentaire c) qui consiste à restaurer la stoechiométrie en oxygène de l'oxyde de départ en soumettant la couche cristallisée obtenue précédemment à une oxydation.

Dans cette dernière étape, on réoxyde ainsi les ions métalliques réduits dans la première étape du procédé, par exemple par traitement thermique sous air de la couche.

Etant donné que la couche cristallisée demeure opaque aux rayonnements, on peut effectuer ce traitement par irradiation au moyen du même rayonnement que celui utilisé pour le recuit, mais en opérant en atmosphère d'oxygène, ce qui permet d'obtenir cette oxydation très rapidement.

L'atmosphère d'oxygène peut être constituée par de l'air et la durée d'irradiation peut être de 0,1 à 300s.

Bien entendu, on pourrait réaliser également cette oxydation par un traitement thermique classique dans un four sous air.

Avec certains oxydes, on peut aussi réaliser simultanément les étapes b) et c), c'est-à-dire que l'on réoxyde la couche pendant l'opération de recuit bien qu'elle soit réalisée sous vide. C'est le cas en particulier des grenats du type $Tr_xCe_{3-x}Fe_5O_{12}$.

Le procédé de l'invention est très intéressant car le fait de réaliser selon l'invention le recuit de l'oxyde par la technique de recuit rapide sous rayonnement permet d'obtenir les avantages suivants :

-   rapidité du cycle de recuit (quelques centaines de secondes au maximum)
-   contrôle de la cristallinité de la couche,
-   contrôle dimensionnel de la cristallisation, par exemple par faisceau laser,
-   contrôle de la granulométrie surtout dans le cas de grains fins, et
-   protection thermique du substrat sous-jacent lorsque celui-ci ne supporte pas les températures mises en jeu pour le recuit.

Le procédé de l'invention peut être utilisé avec tous les oxydes susceptibles d'être rendus absorbants dans le visible par réduction chimique en phase solide.

A titre d'exemple de tels oxydes, on peut citer :

-   les grenats de formule :

$$A_xB_yFe_{5-z}C_zO_{12}$$

dans laquelle A représente une terre rare, B représente Bi ou Ca, C représente Al, Ga, Si, Ge, Sc ou Ti, x+y = 3 et z < 5,
-   les ferrites spinelles de formule :

$$A_xB_yFe_2O_4$$

dans laquelle A et B qui sont différents, représentent Ni, Mn, Zn, Fe, Co, Cu, Mg ou Li, et $x + y = 1$,
- les hexaferrites de formule :

$$A_y, A'_z B_x Fe_{12-x} O_{19}$$

dans laquelle A et A' sont choisis parmi Ba, Sr, Bi, La, Pb et Sc, B représente Co, Mn, Ti, Zn, Al, Cu ou Ga, $y + z = 1$, et $x < 12$,
- les zirconates, titanates, niobates ferroélectriques du type perovskite de formule :

$$ABO_3$$

avec A représentant Ba, Sr, Pb, Bi, La ou Y et B représentant Zr, Nb, Ti, Mn ou Fe ;
- les oxydes acousto optiques / électro optiques, comme $Bi_4 Ge_3 O_{12}$, $LiTaO_3$, $LiNbO_3$, $PbMoO_4$, $Gd_2 (MoO_4)_3$,
- les oxydes à transition de phase tels que $TiO_2$, $VO_2$ et $WO_3$ ;
- les oxydes supraconducteurs, par exemple ceux du type YBaCuO.

Tous ces oxydes ont de nombreuses applications. Parmi ces oxydes, on peut citer en particulier les grenats qui peuvent être utilisés sous la forme de couche mince pour le stockage magnéto-optique d'informations comme on l'a indiqué précédemment.

D'autres caractéristiques et avantages de l'invention apparaîtront mieux à la lecture de l'exemple qui suit donné bien entendu à titre illustratif et non limitatif en référence au dessin annexé sur lequel

- la figure 1 représente de façon schématique une installation pour réaliser le recuit rapide sous rayonnements,
- la figure 2 est un spectre de diffraction aux rayons X de la couche cristallisée obtenue, et
- la figure 3 illustre les propriétés magnétooptiques de la couche obtenue.

L'exemple donné ci-dessous illustre la réalisation d'une couche mince active pour la fabrication de disques thermo-magnéto-optiques réinscriptibles, réalisée à partir d'un grenat de formule :

$$BiDy_2 Ga_{0,3} Fe_{4,7} O_{12}.$$

Dans cet exemple, on utilise le premier mode de mise en oeuvre du procédé de l'invention, c'est-à-dire la formation directe de l'oxyde sous-stoechiométrique lors du dépôt de la couche mince amorphe.

Pour ce dépôt, on utilise un substrat en verre d'un diamètre de 75mm et d'une épaisseur de 1mm, et on dépose sur celui-ci une couche de 1μm d'épaisseur par pulvérisation cathodique du grenat $BiDy_2 Ga_{0,3} Fe_{4,7} O_{12}$ dans une installation de pulvérisation à magnétron du type diode, utilisant 2 cibles face à face de 100mm de diamètre avec le substrat perpendiculaire aux cibles, en opérant dans les conditions suivantes :

- température du substrat : 200°C,
- puissance : 200mA, 350V,
- pression de dépôt : 5mTorr, 0,1% d'oxygène.

Dans ces conditions, on obtient une couche de 1μm d'épaisseur de couleur marron très foncé qui absorbe le rayonnement visible.

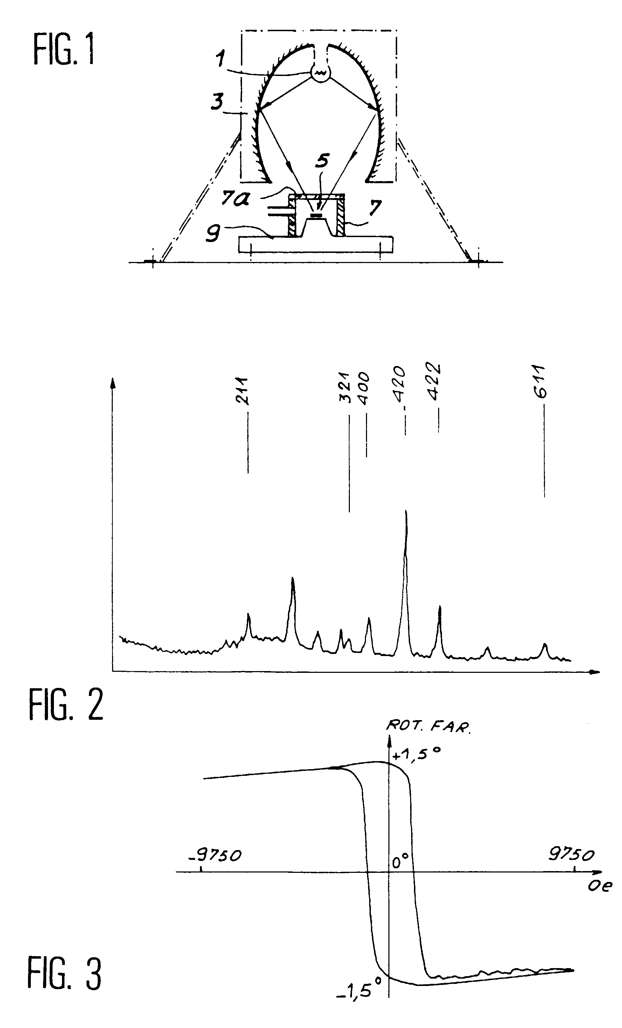

On réalise ensuite le recuit rapide de la couche par irradiation en utilisant l'installation représentée sur la figure 1.

Sur cette figure, on voit que la source d'irradiation est constituée par la lampe 1, d'une puissance de 1kW, qui est disposée dans un réflecteur elliptique doré (3) permettant de focaliser le faisceau de la lampe sur le substrat (5) revêtu de la couche mince d'oxyde sous-stoechiométrique à traiter. Le substrat (5) est disposé dans une enceinte (7) qui peut être mise sous vide, sur un support (9), l'enceinte étant munie d'une paroi supérieure transparente (7a).

Pour réaliser le traitement de recuit, on irradie le substrat (5) revêtu de la couche mince opaque, sous vide, pendant 5s à la pleine puissance de la lampe.

On obtient ainsi une couche cristallisée.

On restaure ensuite la stoechiométrie en oxygène de l'oxyde de la couche cristallisée et on la rend transparente en la soumettant dans la même installation à un chauffage sous air pendant 3s à la pleine puissance de la lampe.

On obtient ainsi une couche mince jaune clair transparent.

On vérifie les propriétés de la couche par diffraction aux rayons X et l'on mesure les caractéristiques magnéto optiques de celle-ci.

Sur la figure 2, on a représenté le diagramme de diffraction des rayons X de la couche. On constate qu'il s'agit bien du grenat cristallisé

$$BiDy_2 Ga_{0,3} Fe_{4,7} O_{12}.$$

La figure 3 représente la rotation Faraday de la couche (en °) en fonction du champ appliqué (en oersted).
Champ coercitif = 1200 oersteds.

La couche présente ainsi les propriétés magnétooptiques suivantes :

- rotation Faraday : 0,75°/μm,
- champ coercitif HC : 1200 oersteds,
- aimantation à saturation MS = 380G, et
- champ d'anisotropie Hk = 2000 oersteds.

On obtient donc de bonnes propriétés magnétooptiques grâce au recuit de l'invention.

## Revendications

1. Procédé de préparation d'une couche mince cristallisée par un traitement de recuit à partir d'un oxyde, caractérisé en ce que ce recuit est effectué par irradiation au moyen d'un rayonnement auquel l'oxyde de départ à l'état amorphe est transparent et en ce que l'on prépare la couche cristallisée en effectuant les étapes suivantes :

   a) préparer une couche mince d'un oxyde sous-stoechiométrique amorphe ayant la même composition que celle de l'oxyde de départ, sauf en ce qui concerne sa teneur en oxygène qui est plus faible de façon à obtenir une couche d'oxyde sous-stoechiométrique opaque et absorbant ledit rayonnement, et
   b) soumettre la couche mince d'oxyde sous-stoechiométrique ainsi obtenue à une irradiation par ledit rayonnement pour la cristalliser.

2. Procédé selon la revendication 1, caractérisé en ce qu'il comprend une étape complémentaire c) consistant à soumettre la couche cristallisée obtenue dans l'étape b) à une oxydation pour restaurer la stoechiométrie en oxygène de l'oxyde de départ et la rendre transparente.

3. Procédé selon la revendication 1, caractérisé en ce que dans l'étape a), on prépare la couche mince d'oxyde sous-stoechiométrique par pulvérisation cathodique de l'oxyde de départ sous une pression partielle d'oxygène inférieure à $135.10^{-4}$ Pa ($10^{-4}$T).

4. Procédé selon la revendication 1, caractérisé en ce que dans l'étape a), on prépare tout d'abord une couche mince amorphe de l'oxyde de départ, transparente audit rayonnement et on soumet la couche mince obtenue à un traitement de réduction pour la rendre sous-stoechiométrique en oxygène et opaque audit rayonnement.

5. Procédé selon la revendication 4, caractérisé en ce que le traitement de réduction est effectué par chauffage à une température de 200 à 450°C dans un mélange d'argon et d'hydrogène.

6. Procédé selon l'une quelconque des revendications 3 et 4, caractérisé en ce que l'on dépose la couche mince d'oxyde sous-stoechiométrique de l'oxyde à cristalliser sur un substrat ne résistant pas à la température de cristallisation de l'oxyde.

7. Procédé selon la revendication 1, caractérisé en ce que dans l'étape b), on utilise un rayonnement du domaine visible et on réalise l'irradiation sous vide pendant une durée allant de 0,1 à 300s.

8. Procédé selon la revendication 1, caractérisé en ce que dans l'étape c), on irradie sous air la couche cristallisée d'oxyde sous-stoechiométrique obtenue dans l'étape b) en utilisant le même rayonnement.

9. Procédé selon la revendication 8, caractérisé en ce que la durée d'irradiation est de 0,1 à 300s.

10. Procédé selon l'une quelconque des revendications 1 à 9, caractérisé en ce que l'oxyde est choisi dans le groupe comprenant les grenats, les ferrites spinelles, les hexaferrites, les perovskites, les oxydes acousto-optiques, les oxydes à transition de phase et les oxydes supraconducteurs.

11. Elément comportant une couche mince de matériau cristallisé du type oxyde déposé sur un support, caractérisé en ce que le support est en matériau ne résistant pas à la température de cristallisation dudit oxyde.

## Claims

1. Process for the preparation of a thin film, crystallized by an annealing treatment from an oxide, characterized in that annealing is carried out by irradiation by means of a radiation to which the starting oxide in the amorphous state is transparent and in that the crystallized film is prepared by carrying out the following stages:

   a) preparing a thin film of an amorphous substoichiometric oxide having the same composition as that of the starting oxide, except with respect to its lower oxygen content, so as to obtain a substoichiometric oxide film, which is opaque and absorbs said radiation and
   b) subjecting the thus obtained thin substoichiometric oxide film to an irradiation by said radiation in order to crystallize it.

2. Process according to claim 1, characterized in that it comprises a complimentary stage c) consisting of subjecting the crystallized film obtained in stage b) to an oxidation in order to restore the oxygen stoichiometry of the starting oxide and make it transparent.

3. Process according to claim 1, characterized in that in stage a) preparation takes place of the thin substoichiometric wide film by cathodic sputtering of the starting oxide under a partial oxygen pressure belay $135.10^{-4}$ Pa ($10^{-4}$T).

**4.** Process according to claim 1, characterized in that in stage a) preparation firstly takes place of a thin, amorphous film of the starting oxide, which is transparent to the said radiation and the thin film obtained undergoes a reduction treatment to make it substoichiometric in oxygen and opaque to the said radiation.

**5.** Process according to claim 4, characterized in that the reduction treatment takes place by heating at a temperature of 200 to 450°C in a mixture of argon and hydrogen.

**6.** Process according to either of the claims 3 and 4, characterized in that the thin substoichiometric oxide film of the oxide to be crystallized is deposited on a substrate unable to withstand the crystallization temperature of the oxide.

**7.** Process according to claim 1, characterized in that in stage b) use is made of radiation in the visible range and irradiation is performed in vacuo for between 0.1 and 300 s.

**8.** Process according to claim 1, characterized in that in stage c) irradiation takes place in air of the substoichiometric crystallized oxide film obtained in stage b) using the same radiation.

**9.** Process according to claim 8, characterized in that the irradiation time lasts 0.1 to 300 s.

**10.** Process according to any one of the claims 1 to 9, characterized in that the oxide is chosen from within the group comprising garnets, spinel ferrites, hexaferrites, perovskites, acoustooptical oxides, phase transition oxides and superconductor oxides.

**11.** Element incorporating a thin film of crystallized material of the oxide type deposited on a support, characterized in that the support is of a material unable to withstand the crystallization temperature of the said oxide.

**Patentansprüche**

**1.** Verfahren zur Herstellung einer kristallisierten dünnen Schicht aus einem Oxid durch eine Wärmebehandlung, dadurch gekennzeichnet, daß diese Wärmebehandlung durch Bestrahlung mit Hilfe einer Strahlung erfolgt, für die das Ausgangsoxid im amorphen Zustand transparent ist, und dadurch, daß man die kristallisierte Schicht herstellt, indem man die folgenden Schritte ausführt:

a) Herstellen einer dünnen Schicht eines amorphen substöchiometrischen Oxids, das bis auf seinen Sauerstoffgehalt, der niedriger ist, die gleiche Zusammensetzung hat wie das Ausgangsoxid, um eine Schicht von opakem und die genannte Strahlung absorbierendem substöchiometrischem Oxid zu erhalten, und

b) Unterziehen der so erhaltenen dünnen Schicht von sub-stöchiometrischem Oxid einer Bestrahlung mit der genannten Strahlung, um die Schicht zu kristallisieren.

**2.** Verfahren nach Anspruch 1, dadurch gekennzeichnet, daß es einen ergänzenden Schritt c) umfaßt, der darin besteht, die in Schritt b) erhaltene kristallisierte Schicht einer Oxidation zu unterziehen, um die Sauerstoff-Stöchiometrie des Ausgangsoxids wiederherzustellen und die Schicht transparent zu machen.

**3.** Verfahren nach Anspruch 1, dadurch gekennzeichnet, daß man in Schritt a) die dünne Schicht von sub-stöchiometrischem Oxid durch Kathodenzerstäubung des Ausgangsoxids unter einem Sauerstoff-Partialdruck kleiner als $135.10^{-4}$ Pa ($10^{-4}$ Torr) herstellt.

**4.** Verfahren nach Anspruch 1, dadurch gekennzeichnet, daß man in Schritt a) zunächst eine amorphe dünne Schicht des Ausgangsoxids herstellt, die für die genannte Strahlung transparent ist, und die erhaltene dünne Schicht einer Reduktionsbehandlung unterzieht, um sie hinsichtlich des Sauerstoffs sub-stöchiometrisch und für die genannte Strahlung opak zu machen.

**5.** Verfahren nach Anspruch 4, dadurch gekennzeichnet, daß die Reduktionsbehandlung durch Erwärmen auf eine Temperatur von 200 bis 450°C in einer Mischung von Argon und Wasserstoff ausgeführt wird.

**6.** Verfahren nach einem der Ansprüche 3 und 4, dadurch gekennzeichnet, daß man die dünne Schicht von sub-stöchiometrischem Oxid des zu kristallisierenden Oxids auf einem Substrat abscheidet, das bei der Kristallisationstemperatur des Oxids nicht beständig ist.

**7.** Verfahren nach Anspruch 1, dadurch gekennzeichnet, daß man in Schritt b) eine Strahlung des sichtbaren Gebiets verwendet und die Bestrahlung unter Vakuum während einer Zeitdauer ausführt, die von 0,1 bis 300 s geht.

**8.** Verfahren nach Anspruch 1, dadurch gekennzeichnet, daß man die in Schritt b) erhaltene kristallisierte Schicht von sub-stöchiometrischem Oxid in Schritt c) an der Luft bestrahlt, wobei man die gleiche Strahlung verwendet.

9. Verfahren nach Anspruch 8, dadurch gekennzeichnet, daß die Bestrahlungsdauer 0,1 bis 300 s beträgt.

10. Verfahren nach einem der Ansprüche 1 bis 9, dadurch gekennzeichnet, daß das Oxid in der Gruppe gewählt wird, welche die Granate, die Spinell-Ferrite, die Hexaferrite, die Perowskite, die akusto-optischen Oxide, die Oxide mit Phasenübergang und die supraleitenden Oxide umfaßt.

11. Element, umfassend eine dünne Schicht eines kristallisierten Materials vom Oxid-Typ, das auf einer Unterlage abgeschieden ist, dadurch gekennzeichnet, daß die Unterlage aus Material ist, das bei der Kristallisationstemperatur des genannten Oxids nicht beständig ist.

FIG. 1

FIG. 2

FIG. 3